# EUROPEAN PATENT APPLICATION

(11) **EP 4 564 674 A1**
(43) Date of publication of application: **04.06.2025**
(21) Application number: 23212939.5
(22) Date of filing: 29.11.2023
(51) Int. Cl.: H03K 17/12, H01L 23/373, H03K 17/687, H03K 17/725

(54) **SOLID STATE SWITCHING POWER MODULE WITH IMPROVED CURRENT RATING**

(71) Applicant: ABB SCHWEIZ AG, 5400 Baden (CH)
(72) Inventor: CANALES, Francisco, 5405 Baden-Dättwil (CH); KICIN, Slavo, 8049 Zürich (CH); SALVATORE, Giovanni, 8125 Zollikerberg (CH)
(74) Representative: Maiwald GmbH

(57) **Abstract**

A solid state switching power module (10), comprising
at least one bipolar semiconductor switch (T1, T2);
at least one unipolar semiconductor switch (J1, J2);
wherein the at least one bipolar semiconductor switch (T1, T2) is connected in parallel with the at least one unipolar semiconductor switch (J1, J2);
wherein the solid state switching power module (10) comprises at least one thermal capacity connected to a surface of the at least one bipolar semiconductor switch (T1, T2);
wherein the at least one thermal capacity is configured to absorb heat from the at least one bipolar semiconductor switch (T1, T2).

## Description

### Field of the invention

The present disclosure relates to solid state switching power module as well as a contactor device comprising said solid state switching power module.

Breaker devices based on solid state technology can have a faster current interruption or current limitation, higher short-circuit breaking capability and higher number of operation without degradation. An example of possible replacement of the mechanical switch by solid state switching is a contactor device. This contactor maintains main benefit of the contactor module exploiting power semiconductors - higher reliability compared to the mechanical switch (many more switching cycles should be possible). Today, a typical contactor device is based on the thyristor device which has very high current and voltage blocking capability. Disadvantage of the solution is a bipolar character of the thyristor device which results in a threshold voltage of several hundred mV. This minimum voltage drop is always present in the thyristor, increasing significantly the losses of the device and thus limiting the current rating of the contactor and/or increasing the thermal requirements.

Semiconductor devices based on a wide band gap material - SiC got recently mature due to the permanent progress in their R&D. This progress helps semiconductors to open doors to power electronics, PE, applications. In order to avoid bottlenecks of the contactor device based on the thyristor, a combination of a SiC JFET and Si thyristor as a main switch in the contactor device has been provided. I/V characteristic of the SiC JFET guarantees low losses at low currents (normal operation of the contactor operation) and the thyristor should take most of the current during overload caused by inrush current, also referred to as surge current.

During turn-on a very high inrush current (several times of nominal) is flowing basically only through the thyristors for several seconds. The time is too short to see an impact of the cooler, therefore, the current rating of the contactor device is limited mainly by capability of the module structure close to the thyristor to absorb dissipated energy without overheating the device.

Thus, there is a need for a power module for a contactor device with improved current rating.

### Summary

The present invention is defined by the subject-matter of the independent claims. Additional features of the invention are presented in the dependent claims.

According to an aspect of the invention, a solid state switching power module comprises at least one bipolar semiconductor switch and at least one unipolar semiconductor switch. The at least one bipolar semiconductor switch is connected in parallel with the at least one unipolar semiconductor switch. The solid state switching power module comprises at least one thermal capacity connected to a surface of the at least one bipolar semiconductor switch. The at least one thermal capacity is configured to absorb heat from the at least one bipolar semiconductor switch.

In other words, in case of an overload current running through the at least one bipolar semiconductor switch, the at least one thermal capacity allows to absorb the heat that is created by the overload current running through the at least one bipolar semiconductor switch. This allows to increase the current rating of the solid state switching power module.

In case of an overload current, for example at switch-on of the solid state switching power module, through the solid state switching power module, most of this increased current runs through the at least one bipolar semiconductor switch. Due to the parallel connection of the at least one bipolar semiconductor switch and the at least one unipolar semiconductor switch, at switch-on of the solid state switching power module, most of the overload current runs through the at least one bipolar semiconductor switch. Thus, the current rating of the solid state switching power module is limited by a capability of the solid state switching power module to absorb or dissipate the heat that is created by the overload current running through the at least one bipolar semiconductor switch. Usually, the at least one bipolar semiconductor switch is mounted in a direct bonded copper, DBC, that rather works as a heat insulator rather than a heat conductor. Thus, a heat sink that is usually mounted on the other side of the DBC is rather limited in the capability of absorbing or dissipating the overload heat from the at least one bipolar semiconductor switch.

Compared to conventional cooling devices, like a heat sink module, the thermal capacity directly connected to the at least one bipolar semiconductor switch allows the at least one bipolar semiconductor switch to withstand a higher overload current and as such allows the solid sate switching power module to be dimensioned with an increased current rating.

In other words, the thermal capacity is directly connected to the at least one bipolar semiconductor switch and as such allows for a quick absorption of the heat caused by the operation of the at least one bipolar semiconductor switch, in particular by the operation with overload current. Consequently, the thermal capacity is dimensioned in such a way that it fits into a package of the solid state switching power module, is connected to a surface of the at least one bipolar semiconductor switch and has enough thermal capacity and thermal connectivity to absorb the heat caused by the at least one bipolar semiconductor switch running with the overload current.

The term "absorb heat", as used herein, comprises the sole absorption of heat, but also the dissipation of the absorbed heat.

Preferably, a thermal capacity is connected to a surface of each of the at least one bipolar semiconductor switches. In other words, each of the at least one bipolar semiconductor switches is directly connected to a thermal capacity.

Preferably, the overload current, which in the case of the switch-on is also referred to as inrush current, is higher, in particular multiple times higher, than a nominal current running through the solid state switching power module during normal operation.

The thermal capacity is a relatively small structure. The at least one thermal capacity provide a relatively cheap solution to increase the current rating of the solid state switching power module.

For example, solid state switching power modules for contactor devices have a current rating of 10 Ampere, wherein the solid state switching power module as presented provides a current rating of around 20 Ampere.

Thus, a power module for a contactor device with improved current rating is provided.

In a preferred embodiment, the solid state switching power module comprises a direct bonded copper, DBC, wherein on a first side of the DBC, the at least one bipolar semiconductor switch is disposed. On a second side of the DBC, a heat sink module is disposed. The heat sink module is configured to absorb heat from the at least one bipolar semiconductor switch and the at least one unipolar semiconductor switch.

The DBC preferably comprises a baseplate, soldering and thermal grease that increases the thermal resistance of the solid state switching power module, limiting the capability to absorb the heat by the heat sink.

During normal operation of the solid state switching power module, the heat sink module absorbs and dissipates heat that is caused by the operation of the solid state switching power module, in particular by the operation of the at least one bipolar semiconductor switch and/or the at least one unipolar semiconductor switch. However, as outlined above, the heat sink module is located at an opposite side of the DBC compared with the semiconductor switches. Consequently, the heat caused by overload current running through the at least one bipolar semiconductor switch cannot be efficiently absorbed and dissipated by the heat sink module.

In other words, the heat sink module is configured to absorb the normal operation heat of the solid state switching power module, and thus the at least one bipolar semiconductor switch. The normal operation heat comprises the heat that the at least one bipolar semiconductor switch and the at least one unipolar semiconductor switch cause by their operation with the nominal current. In contrast, the at least one thermal capacity is configured to absorb overcurrent heat of the at least one bipolar semiconductor switch. The overcurrent heat comprises the heat that the at least one bipolar semiconductor switch cause by its operation with the overcurrent.

Alternatively, instead of a DBC, a printed circuit board, PCB, is used to dispose the semiconductor switches on.

In a preferred embodiment, the at least one thermal capacity is disposed on a top side of the at least one bipolar semiconductor switch, wherein the top side is a side of the at least one bipolar semiconductor switch turned away from the DBC.

As there is usually some space above the at least one bipolar semiconductor switch within the package of the solid state switching power module, the at least one thermal capacity is disposed and connected on the top side of the at least one bipolar semiconductor switch. This provides room for the thermal capacity within the solid state switching power module and also provides enough room for also dissipating at least some of the absorbed heat into the environment.

In a preferred embodiment, the thermal capacity is disposed on a bottom side of the at least one bipolar semiconductor switch, wherein the bottom side is a side of the at least one bipolar semiconductor switch turned towards the DBC.

In other words, the at least one thermal capacity is disposed between the at least one bipolar semiconductor switch and the DBC. The at least one bipolar semiconductor switch thus does not need a specific connection means for the thermal capacity, because the at least one bipolar semiconductor switch is just directly connected to the DBC via the at least one thermal capacity.

In a preferred embodiment, the at least one thermal capacity comprises a first thermal capacity disposed on a top side of the at least one bipolar semiconductor switch, wherein the top side is a side of the at least one bipolar semiconductor switch turned away from the DBC, and a second thermal capacity disposed on a bottom side of the at least one bipolar semiconductor switch, wherein the bottom side is a side of the at least one bipolar semiconductor switch turned towards the DBC.

In other words, the first thermal capacity is disposed on top of the at least one bipolar semiconductor switch and the second thermal capacity is disposed between the at least one bipolar semiconductor switch and the DBC. This allows a flexible usage of the available space within the package of the solid state switching power module. Furthermore, this increases the heat dissipation from the at least one bipolar semiconductor switch to the at least one thermal capacity due to the increased connection surface, namely the top side and the bottom side of the at least one bipolar semiconductor switch.

This allows a further increase of overload current through the at least one bipolar semiconductor switch.

Thus, a power module for a contactor device with improved current rating is provided.

In a preferred embodiment, the thermal capacity comprises a preform.

The term "preform", as used herein, comprises a soldering molded part. The preform can be made from different materials/compounds and different forms. Preferably, the soldering volume of the preform is adjusted to the soldering point, in particular the connection surface with the at least one bipolar semiconductor switch.

This allows to easily connect the thermal capacity to the at least one bipolar semiconductor switch.

In a preferred embodiment, a surface of the at least one bipolar semiconductor switch comprises connection means to connect with the at least one thermal capacity.

Preferably, the connection means comprise any one of a soldering pad, a clip connection and wirebonding.

Preferably, the connection means allow for a high heat conducting connection between the at least one thermal capacity and the at leads one bipolar semiconductor switch.

In a preferred embodiment, the thermal capacity has solderable, sinterable surface finish for connection to a metallization of the at least one bipolar semiconductor switch.

The surface finish of the thermal capacity preferably comprises silver, copper, nickel or gold.

In a preferred embodiment, the at least one thermal capacity comprises a structure at a surface of the thermal capacity for improved heat dissipation.

Preferably, the structure comprises at least one pin or at least one groove, to improve heat dissipation form the thermal capacity, for example into the environment. Heat dissipation is also referred to as heat radiation.

In a preferred embodiment, the at least one bipolar semiconductor switch comprises a thyristor and the at least one unipolar semiconductor switch comprises a junction-gate field effect transistor, JFET.

In a preferred embodiment, the JFET is a Silicon carbide, SiC, JFET or a Gallium nitride, Gan, JFET.

In a preferred embodiment, the thermal capacity covers at least 90% of a surface of the bipolar semiconductor switch.

In a preferred embodiment, a thickness of the thermal capacity is between 0.5mm and 10mm.

A thick metallization of the at least one bipolar semiconductor switch thus does not provide a sufficient thermal capacity.

In a preferred embodiment, the thermal capacity is made at least in part of copper, aluminum, molybdenum and/or a composition thereof.

Copper, aluminum, molybdenum and/or a composition thereof provide a relatively high thermal capacity and heat conductivity. It is important that the thermal capacity can provide enough thermal capacity and heat conductivity to dissipate the heat from the at least one bipolar semiconductor switch caused by operating the at least one bipolar semiconductor switch with the overload current.

According to another aspect of the invention, a contactor device comprises a solid state switching power module, as described herein.

The subject matter of the invention will be explained in more detail in the following text with reference to preferred exemplary embodiments which are illustrated in the attached drawings.

### Brief description of the drawings

Exemplary embodiments of the invention will be described in the following with reference to the accompanying drawings:
Fig. 1 illustrates electrical schematics of the semiconductor switches of the solid state switching power module; and
Fig. 2 illustrates a solid state switching power module in accordance with the invention.

Fig .1 illustrates electrical schematics of the semiconductor switches of the solid state switching power module 10.

The solid state switching power module 10 comprises an input node Ni into which an input current flows into the solid state switching power module 10. Furthermore the solid state switching power module 10 comprises an output node No from which an output current flows outside the solid state switching power module 10.

The solid state switching power module 10 comprises a first branch 11, also referred to as bipolar based branch. Furthermore, the solid state switching power module 10 comprises a second branch 12, also referred to as unipolar based branch. The first branch 11 and the second branch 12 are connected in parallel and both connect the input node Ni with the output node No.

The first branch 11 comprises a first thyrisor T1 and a second thyrisor T2. The first thyristor T1 and the second thyristor T1 are bipolar semiconductor switches. The first thyristor T1 and the second thyristor T2 are connected to each other in parallel. Furthermore, the first thyristor T1 comprises a first anode connected with the input node Ni and a first cathode connected with the output node No. Furthermore, the second thyristor T2 comprises a second anode connected with the output node No and a second cathode connected with the input node Ni.

The second branch 12 comprises a first JFET J1, a second JFET J2, a first MOSFET M1 and a second MOSFET M2 connected with each other in series. The first JFET J1 is connected with the input node Ni and the first MOSFET M1. The first MOSFET M1 is connected with the first JFET J1 and the second MOSFET M2, The second MOSFET M2 is connected with the first MOSFET M1 and the second JFET J2. The second JFET J2 is connected with the second MOSFET M2 and the output node No.

As the first JFET J1 and the second JFET J2 are normally-on devices, the first MOSFET M1 and the second MOSFET M2 are necessary to connect the first JFET J1 and the second JFET J2 in series.

The combination of the thyristor based first branch 11 and the JFET based second branch 12 is also referred to as ThyFET. The ThyFET allows for low losses at low currents due to the second branch 12 while the first branch takes most of the current during overload, in particular caused by inrush current.

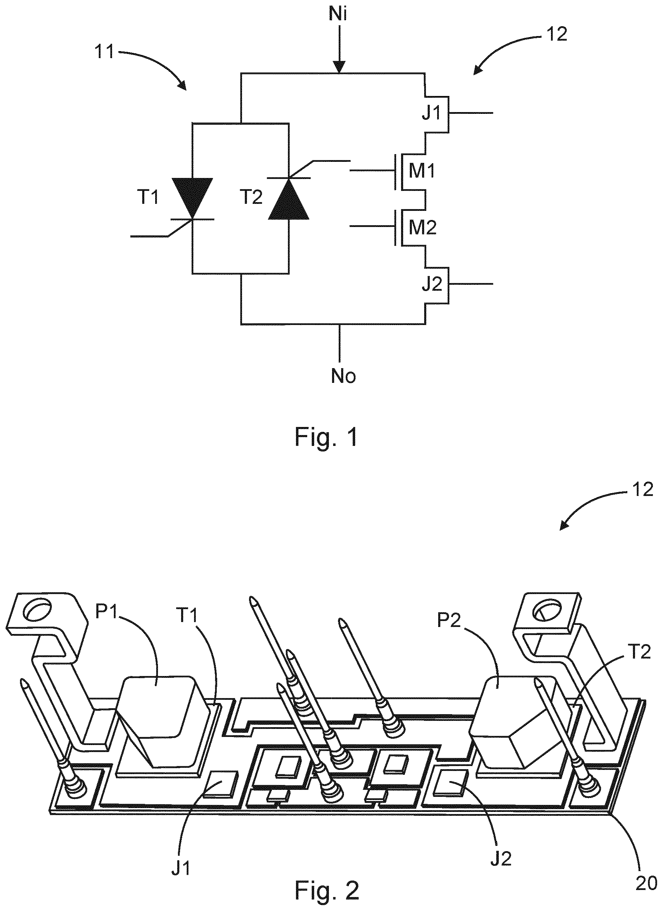

Fig. 2 illustrates a solid state switching power module 10 in accordance with the invention. In line with the schematical view of fig. 1, the solid state switching power module 10 comprises the first thyristor T1, the second thyristor T2, the first JFET J1, the second JFET J2, the first MOSFET M1 and the second MOSFET M2 with the same layout as shown in fig. 1. As outlined in fig, 1, the first thyristor T1 or the second thyristor T2 take most of the inrush current in a switch-on state. The inrush current leads to a fast heat generation of the first thyristor T1 or the second thyristor T2. Thus, the solid state switching power module 10 has a current rating that is dimensioned based on the parts of the solid state switching power module 10, in particular the first thyristor T1 and the second thyristor T2 and further in particular the capability of the first thyristor T1 and the second thyristor T2 to handle the inrush current.

The solid state switching power module 10 comprises a DBC 20. On a top side of the DBC, the semiconductor switches are mounted on. On a bottom side, which is opposed to the top side, a heat sink module (not shown) is disposed that is configured to absorb and dissipate the heat generated by the solid state switching power module 10. The DBC however functions rather as a heat insulator than a heat conductor. Thus, a fast heat surge, which for example occurs during running the inrush current through the first thyristor T1 or the second thyristor T2, the heat sink module is not responsive enough the absorb and dissipate much of the so called overload heat.

Thus, the solid state switching power module 10 has a current rating that is dimensioned in particular on the capability of the first thyristor T1 and the second thyristor T2 not to overheat due to the inrush current. Therefore, the first thyristor T1 and the second thyristor T2 must not exceed a predetermined temperature, in particular 150 degree Celsius. In other words, the current rating of the solid state switching power module 10 is limited by the capability of the first thyristor T1 and the second thyristor T2 to stay below 150 degree Celsius in a switch-on scenario, wherein the inrush current flows through the first thyristor T1 or the second thyristor T2.

Thus, the first thyristor T1 is directly connected to a first thermal capacity in form for a preform P1 and the second thyristor T2 is directly connected to a second thermal capacity in form of a second preform P2. For example, the connections comprise soldering, sintering, gluing, Transient liquid phase, TLP, bonding or brazing

The first preform P1 and the second preform P2 comprise a material with high thermal capacity and connectivity. Thus, during the switch-on, the overload heat that is caused by the inrush current flowing through the first thyristor and/or the second thyristor is absorbed and dissipated by the first preform P1 and the second preform P2.

In other words, the first preform P1 and the second preform P2 are directly connected to the first thyristor T1 and the second thyristor T2, respectively, in particular directly mounted on a surface or side of the respective first thyristor T1 and second thyristor T2, allowing to handle a significant part of the generated overload heat. In a scenario compared with a solid state switching power module 10 without the preforms P1, P2, the thyristors T1, T2 have a temperature that is 8-20 degree Celsius lower. Consequently, the preforms P1, P2 allow increasing the current rating of the solid state switching power module 10. Preferably, the preforms P1, P2, in other words the heat capacities, allow doubling the current rating, for example from 10 Ampere to 20 Ampere.

Thus, a power module 10 for a contactor device with improved current rating is provided.

### List of references

- 10: solid state switching power module
- 20: direct bonded copper
- T1: first thyristor
- T2: second thyristor
- J1: first JFET
- J2: second JFET
- M1: first MOSFET
- M2: second MOSFET

## Claims

1. Solid state switching power module (10), comprising:
at least one bipolar semiconductor switch (T1, T2);
at least one unipolar semiconductor switch (J1, J2);
wherein the at least one bipolar semiconductor switch (T1, T2) is connected in parallel with the at least one unipolar semiconductor switch (J1, J2);
wherein the solid state switching power module (10) comprises at least one thermal capacity connected to a surface of the at least one bipolar semiconductor switch (T1, T2);
wherein the at least one thermal capacity is configured to absorb heat from the at least one bipolar semiconductor switch (T1, T2).

2. Solid state switching power module of any one of the preceding claims,
comprising a direct bonded copper, DBC (20), wherein on a first side of the DBC (20), the at least one bipolar semiconductor switch (T1, T2) is disposed;
wherein on a second side of the DBC (20), a heat sink module is disposed;
wherein the heat sink module is configured to absorb heat from the at least one bipolar semiconductor switch (T1, T2) and the at least one unipolar semiconductor switch (J1, J2).

3. Solid state switching power module of claim 2,
wherein the at least one thermal capacity is disposed on a top side of the at least one bipolar semiconductor switch (T1, T2), wherein the top side is a side of the at least one bipolar semiconductor switch (T1, T2) turned away from the DBC (20).

4. Solid state switching power module of claim 2,
wherein the at least one thermal capacity is disposed on a bottom side of the at least one bipolar semiconductor switch (T1, T2), wherein the bottom side is a side of the at least one bipolar semiconductor switch (T1, T2) turned towards the DBC (20).

5. Solid state switching power module of claim 2,
wherein the at least one thermal capacity comprises a first thermal capacity disposed on a top side of the at least one bipolar semiconductor switch (T1, T2), wherein the top side is a side of the at least one bipolar semiconductor (T1, T2) switch turned away from the DBC (20), and a second thermal capacity disposed on a bottom side of the at least one bipolar semiconductor switch (T1, T2), wherein the bottom side is a side of the at least one bipolar semiconductor switch (T1, T2) turned towards the DBC (20).

6. Solid state switching power module of any one of the preceding claims,
wherein the at least one thermal capacity comprises a preform.

7. Solid state switching power module of any one of the preceding claims,
wherein a surface of the at least one bipolar semiconductor switch (T1, T2) comprises connection means to connect with the thermal capacity.

8. Solid state switching power module of any one of the preceding claims,
wherein the thermal capacity has solderable, sinterable surface finish for connection to a metallization of the at least one bipolar semiconductor switch (T1, T2).

9. Solid state switching power module of any one of the preceding claims,
wherein the at least one thermal capacity comprises a structure at a surface of the thermal capacity for improved heat dissipation.

10. Solid state switching power module of any one of the preceding claims,
wherein the at least one bipolar semiconductor switch (T1, T2) comprises a thyristor; and
wherein the at least one unipolar semiconductor switch (J1, J2) comprises a junction-gate field effect transistor, JFET .

11. Solid state switching power module of any one of claim 10,
wherein the JFET is Silicon carbide, SiC, JFET or a Gallium nitride, Gan, JFET.

12. Solid state switching power module of any one of the preceding claims,
wherein the at least one thermal capacity covers at least 90% of a surface of the bipolar semiconductor switch (T1, T2).

13. Solid state switching power module of any one of the preceding claims,
wherein a thickness of the at least one thermal capacity is between 0.5mm and 10mm.

14. Solid state switching power module of any one of the preceding claims,
wherein the at least one thermal capacity is made at least in part of copper, aluminum, molybdenum and/or a composition thereof.

15. Contactor device comprising a solid state switching power module (10) in accordance with any one of the claims 1-14.
